# EUROPEAN PATENT APPLICATION

(11) **EP 1 763 038 A1**
(43) Date of publication of application: **14.03.2007**
(21) Application number: 05019625.2
(22) Date of filing: 08.09.2005
(51) Int. Cl.: G11C 16/02

(54) **Method for writing data into a memory cell of a conductive bridging random access memory, memory circuit and CBRAM memory circuit**

(71) Applicant: Infineon Technologies AG, 81669 München (DE)
(72) Inventor: Röhr, Thomas, 85609 Aschheim (DE)
(74) Representative: Patentanwaltskanzlei WILHELM & BECK

(57) **Abstract**

The present invention refers to a method for writing data in a memory cell of a conductive bridging random access memory (CBRAM), whereby the CBRAM memory comprises a plate line, bit lines and memory cells, each memory cell comprises a programmable metallization cell (PMC), whereby the memory cells are connected with a respective bit line and the plate line, whereby a first, a second and a third bit line is arranged side by side, whereby data is written in a first memory cell by changing the resistance value of a first PMC cell of the first memory cell by applying a writing voltage to the first bit line that is connected with the first memory cell, whereby the adjacent second and third bit line that are connected with a second and a third memory cell are put at the same time to writing voltages corresponding to the data stored in the second and third memory cell, and data are written in the first, second and third memory cell during the same writing cycle.

## Description

### Background of the invention

### 1. Field of the invention

The present invention refers to a method for writing data into a memory cell of a conductive bridging random access memory and to a memory circuit comprising memory cells with programmable metallization cells, particularly a CBRAM memory circuit.

### 2. Description of the related art

Memory cells comprising a solid electrolyte material are well known as PMC (programmable metallization cell) memory cells. Memory devices including such PMC memory cells are known as CBRAM (conductive-bridging random access memory) devices. The storing of different states in a PMC memory cell is based on the developing or diminishing of a conductive path in the electrolyte material between electrodes based on an applied electrical field. Although the electrolyte material has a high resistance, the conductive path between electrodes has a low resistance. Thereby, the PMC memory cell can be set to different states depending on the resistance of the PMC memory element. Usually, both states of the PMC memory cell are sufficiently time-stable in such a way that data may permanently be stored.

A PMC memory cell is operated by applying a positive or a negative voltage to the solid electrolyte of the PMC memory element. In order to store data into the PMC memory cell, the PMC memory cell is brought to a programmed stated by applying a suitable programming voltage to the PMC memory cell which results in the development of the conductive path in the electrolyte material and therefore in the setting of a first state with low resistance. In order to store a second state in the PMC memory cell with high resistance, an erase voltage has to be supplied in such a manner that the resistance of the PMC memory cell changes back to a high resistance which refers to an erased state. To read out a PMC memory cell, a read voltage is applied that is lower than the programming voltage. With the read voltage, a current through the resistance of the PMC memory element is detected and associated to the respective low or high resistance state of the PMC memory cell.

US 6,865,117 B2 describes a programming circuit for a programmable microelectronic device, a system including the circuit and a method for forming the same. The circuit is configured to provide a reversible bias across the microelectronic device to perform erase and write functions. One configuration of the programming circuit includes one or more inputs and a complementary metal-oxide semiconductor circuit coupled to the programmable device. This design allows for writing and erasing of the programmable cell using a low and a high voltage input. Depending on the state that should be programmed into the PMC cell, a high voltage is applied to the anode and a low voltage is applied to the cathode or, respectively, a low voltage is applied to the anode and a high voltage is applied to the cathode of the PMC cell.

### Summary of the invention

The object of the present invention is to provide a method for writing data in a memory cell of a conductive bridging random access memory by which the programming operation is less sensitive to voltage crosstalk between bit lines.

A further aspect of the invention is to provide a memory circuit comprising memory cells with programmable metallization cells with a solid electrolyte which is less sensitive with respect to voltage crosstalk between bit lines.

Another aspect of the present invention is to provide a CBRAM memory circuit with memory cells comprising programmable metallization cells whereby the CBRAM memory circuit is less sensitive to voltage crosstalk between bit lines.

These objects are achieved by the method for writing data into a memory cell of a conductive bridging random access memory according to claim 1, a memory circuit according to claim 5 and a CBRAM memory circuit according to claim 8.

Preferred embodiments of the present invention are defined in the dependent claims.

The present invention is a method for writing data in a memory cell of a conductive bridging random access memory. The memory cell comprises a programmable metallization cell. The CBRAM memory comprises a plate line, bit lines and memory cells, each memory cell comprising a programmable metallization cell. The memory cells are connected to a bit line and the plate line. A first, a second and a third bit line are arranged side by side, whereby data is written into the first memory cell by changing the resistance value of a first PMC cell of the first memory cell by applying a writing voltage to the first bit line which is connected to the first memory cell. At the same time, the adjacent second and third bit lines are set to a writing voltage and data are written into the second and third memory cell during the same cycle. This method has the advantage that the adjacent bit lines have the same voltage level during the writing operation and therefore there is less influence of voltage crosstalk due to the writing voltage on the adjacent bit lines.

Furthermore, the present invention is a memory circuit comprising a plate line, bit lines and memory cells, each memory cell comprising a programmable metallization cell with a solid electrolyte which is adapted to selectively develop or diminish a conductive path depending on the applied electrical field. The memory cell is arranged between a bit line and the plate line. Furthermore, a writing unit is disposed, whereby the writing unit is connected with bit lines which are arranged side by side, whereby the writing unit is configured to change a resistive state of a PMC cell to a programmed state by applying a writing voltage to a bit line which is connected with the PMC cell and to change the resistive state of a programmed PMC cell. Furthermore, the memory circuit comprises a controlling unit that is connected to the writing unit, whereby the controlling unit is configured to control the writing unit to apply writing voltages to at least three adjacently arranged bit lines if at least a date is written into one memory cell that is connected to one of the adjacent bit lines. Additionally, an output unit is disposed that is connected with the bit lines for reading out data from the memory cells.

Furthermore, the present invention relates to a CBRAM memory circuit comprising a plate line, bit lines, word lines and memory cells, each memory cell comprising a switch and a programmable metallization cell with a solid electrolyte which is adapted to selectively develop and diminish a conductive path depending on the applied electrical field. The memory cell is arranged between a bit line and the plate line, whereby a controlling input of the switch is connected to a word line. A word line driver circuit is arranged, configured to select one of the word lines and to change the voltage of the selected word line to close or open the switches of the memory cells that are connected with the selected word line. Additionally, a writing unit is disposed, configured to change a state of a PMC cell to a programmed state by applying a writing voltage to the bit line of the PMC cell. The CBRAM memory circuit comprises a voltage unit connected to the plate line and configured to apply a plate voltage to the plate line according to the writing operation of the PMC cell to increase the voltage drop over the PMC cell to assist the writing operation.

The present invention is based on the idea of providing a method for writing data into a memory cell of a conductive bridging random access memory, whereby during the writing operation adjacent bit lines are set to writing voltages corresponding to the stored data, although a date should be written into only one of the memory cells of the adjacent bit lines. This method has the advantage that voltage crosstalk has less influence between the bit lines which are held at the writing voltages during the writing operation.

The idea of holding adjacently arranged bit lines at the writing voltages corresponding to the data stored therein during the writing operation can be used in any memory circuit, particularly in a CBRAM memory circuit.

### Brief description of the drawings

These and other objects and features of the present invention will become clear from the following description taken in conjunction with the accompanying drawings in which:
Figure 1 is a schematic view of a conductive-bridging junction of a PMC cell;
Figure 2 shows a diagram of the current depending on the voltage drop over the PMC cell for a program, read and erase state;
Figure 3 depicts a part of a CBRAM memory; and
Figure 4 shows a diagram for a writing, an erasing and a reading operation.

### Description of the preferred embodiments

The present invention may be described in terms of various functional components. It should be appreciated that such functional components may be realized by any number of hardware or structural components configured to perform the specified functions. For example, the present invention may employ various integrated components comprised of various electrical devices, e.g. resistors, transistors, capacitors, diodes and such like, the values of which may be suitably configured for various intended purposes. In addition, the present invention may be practiced in any integrated circuit application where an effective reversible polarity is desired. Such general applications which may be appreciated by those skilled in the art in light of the present disclosure are not described in detail. Further, it should be noted that while various components may be suitably coupled or connected to other components within exemplary circuits, such connections and couplings can be realized by direct connection between components and by connection through other components and devices located in between.

The present invention generally relates to a method for operating a programmable metallization cell of a conductive bridging random access memory, an electrical circuit comprising a PMC cell with a solid electrolyte and a CBRAM memory cell comprising programmable metallization cells.

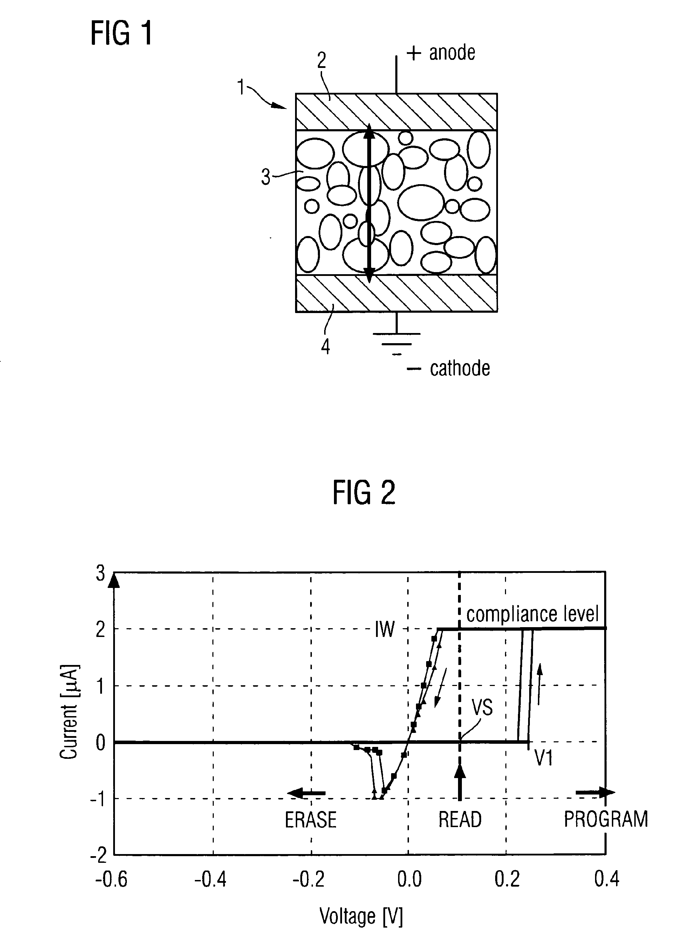

In a schematic view, Figure 1 depicts a conductive bridging junction of a PMC cell 1 comprising an anode 2, a cathode 4 and an electrolyte layer 3 in between. The cathode 4 is connected to a ground potential and the anode 2 may be connected to a high potential in the depicted situation that shows a programming operation.

The structure shown in Figure 1 may be used in order to store information and thus may be used in memory circuits. For example, the conductive bridging junction or other programmable structure in accordance with the present invention may be suitably used in memory devices to replace DRAM, SRAM, PROM, EEPROM, flash devices or any combination of such memories. In addition, programmable structures of the present invention may be used for other applications where programming or changing of electrical properties of a portion of an electrical circuit are desired.

The electrolyte layer 3 is formed by material which conducts ions upon application of a sufficient voltage. Suitable materials for ion conductors include polymers, glasses and semiconductor materials. In one exemplary embodiment of the invention, the electrolyte layer 3 is formed by chalcogenides material. The electrolyte layer 3 may also suitably include dissolved and/or dispersed conductive material. For example, the electrolyte layer 3 may comprise a solid solution that includes dissolved metals and/or metal ions. The chalcogenides materials including silver, copper, combinations of these materials and such like could be used for constituting the electrolyte layer 3.

The anode 2 and the cathode 4 may be formed by any suitable conductive material. For example, the anode 2 and the cathode 4 may be formed by doped polysilicon material or metal. In accordance with one exemplary embodiment of the present invention, one of the electrodes, i.e. the anode 2, is formed by a material including a metal which dissolves in ion conductors when a sufficient bias is applied across the electrodes and the other electrode, i.e. the cathode is relatively inert and does not dissolve during operating of the programmable device. The first electrode 2 may be an anode during a write operation and be comprised of a material including silver which dissolves in the electrolyte layer. The second electrode 4 may be a cathode during the write operation and be comprised of an inert material such as tungsten, nickel, molybdenum, platinum, metal silicides, and such like.

The conductive bridging junction is configured in such a way that when a bias larger than a threshold voltage is applied across the electrodes 2, 4, the electrical properties of the electrolyte layer 3 change. If a voltage is applied larger than the threshold voltage, conductive ions within the electrolyte layer start to migrate and to form a region having an increased conductivity compared to the conductor at or near the more negative of the electrodes 2, 4. As the conductive region forms, the resistance between the electrodes 2, 4 decreases and other electrical properties may also change. If the same voltage is applied in reverse, the conductive region will dissolve back into the electrolyte layer and the device will return to a high resistance or erased state.

The basic reaction is if a higher voltage is applied at the anode 2, a redox reaction at the cathode 4 drives metal ions from the reactive anode into the electrolyte layer 3. Therefore, in the electrolyte layer 3, metal-rich clusters are formed. The result is a conductive bridge that occurs between the anode and the cathode. If a reverse voltage is applied to the PMC cell 1, the metal-rich clusters are dissolved and the conductive bridge is degraded.

Figure 2 shows a diagram of the voltage and the current occurring during a programming operation, a read operation and an erase operation of a PMC cell 1, whereby the programming and the erasing operation constitute writing operations which are used to store a date in a memory cell. At the start, the PMC cell is not programmed and therefore has a high resistance. If a voltage is applied with a higher voltage at the anode 2 and a lower voltage at the cathode 4, no current flows through the PMC cell 1 until a threshold voltage V1 is applied. With the voltage rising over the threshold voltage V1, current starts to flow until a working current IW is achieved which is confined by the programming circuit. The voltage is then reduced to 0 Volt, whereby the current falls to 0 A. Now the PMC cell is programmed.

If the program status is to be sensed or read, a sensing voltage is applied to the PMC cell which is lower than the threshold voltage V1. The sensing voltage VS may be about 0.1 Volt. Due to the sensing voltage, a working current IW flows through the PMC cell. Without the programming operation, no current would flow through the PMC cell applied to a sensing voltage. To erase the program status, a lower voltage, i.e. a negative voltage is applied to the anode 2 starting at 0 Volt. Up to a negative voltage of about -0.1 Volt, a negative current flows through the PMC cell 1, but when the negative voltage drops over - 0.1 Volt, the current goes down to 0 A. Now the PMC cell 1 again has the same high resistance as prior to the programming operation.

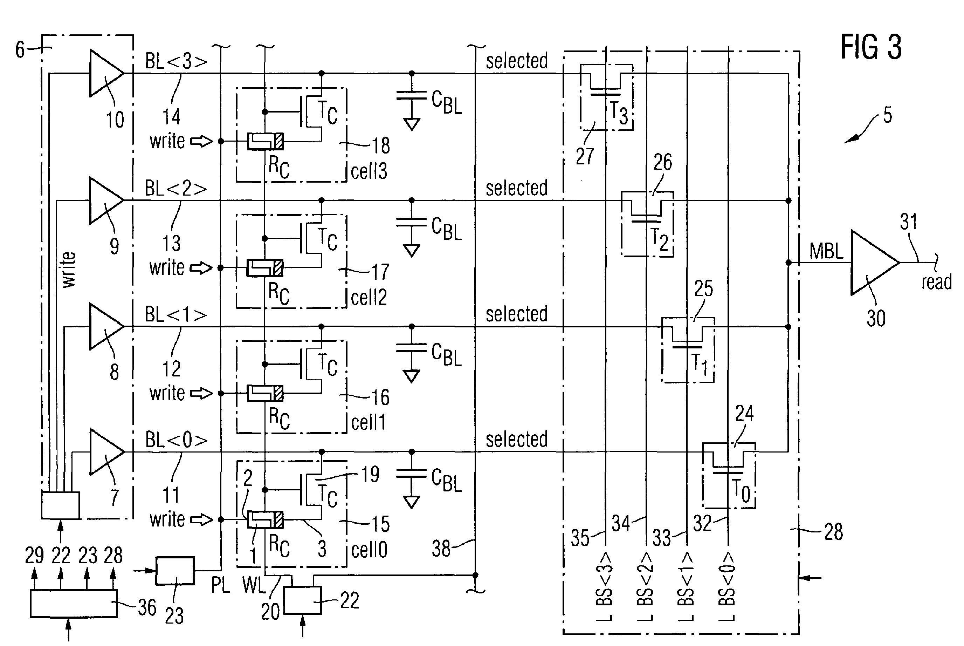

Figure 3 depicts a part of an electrical circuit, e.g. a CBRAM 5. The electrical circuit comprises memory cells 15, 16, 17, 18, whereby each memory cell comprises a PMC cell 1 and a switch 19. A cathode of a PMC cell 1 is connected to a plate line 21 and an anode of a PMC cell 1 is connected to a switch 19. A switch 19 is connected to a bit line 11, 12, 13, 14, whereby a controlling input of a switch 19 is connected to a word line 20. The switches 19 may be constituted by field effect transistors which connect the PMC cells 1 to respective bit lines 11, 12, 13, 14 depending on the voltage of the word line 20. In Figure 3, only one row of memory cells is depicted, however, several word lines are disposed whereby each word line is connected to a row of memory cells.

The plate line 21 is connected to a plate line driver 23. The word line 20 is connected to a word line driver 22. The first, the second, the third and fourth bit line 11, 12, 13, 14 are connected to a writing unit 6 and a multiplexing unit 28. The writing unit 6 comprises a controlling unit 29 and a first, a second, a third and a fourth amplifier 7, 8, 9, 10 which are connected to the respective first, second, third or fourth bit line 11, 12, 13, 14.

The second endings of the first, second, third, fourth bit line 11, 12, 13, 14 are connected to first, second, third, fourth further switches 24, 25, 26, 27 which are part of the multiplexing unit 28. Outputs of the further switches 24, 25, 26, 27 are connected to an output of the multiplexing unit 28. The output of the multiplexing unit 28 is connected to an output unit 30. The output unit 30 comprises an amplifier and a sensing unit and a further output 31.

Each further switch 24, 25, 26, 27 comprises a controlling input which is connected to a controlling line 32, 33, 34, 35. Depending on the voltage on the controlling lines, the further switches 24, 25, 26, 27 connect the bit lines 11, 12, 13, 14 to the output unit 30. The further switches 24, 25, 26, 27 may be constituted as n-channel field effect transistors.

In a simple embodiment of the invention, each bit line 11, 12, 13, 14 is connected to a respective output unit 30. Thus, a multiplexing unit 28 is not necessary, however, then the number of output units 30 corresponds to the number of bit lines 11, 12, 13, 14.

Furthermore, depending on the embodiment of the invention, for each bit line 11, 12, 13, 14, a separate writing unit 6 may be disposed which is controlled by a common controlling unit 29. The writing unit 6 is configured to raise or to lower the voltage on the first, the second, the third or the fourth bit line 11, 12, 13, 14, depending on controlling signals of the controlling unit 29. This is necessary for writing data into the memory cells 15, 16, 17, 18. The plate line driver 23 is configured to raise or to lower the voltage on the plate line 21. The voltage on the plate line 21 may be used to increase the voltage drop over the PMC cell of a memory cell. The word line driver 22 is configured to increase or to decrease a voltage on the word line. If, for example, n-channel field effect transistors are used as switches 19 for the memory cells 15, 16, 17, 18, the anodes of the PMC cells of the memory cells may be connected with the respective first, second, third, fourth bit line 11, 12, 13, 14 by increasing the voltage on the word line 20.

Furthermore, the CBRAM 5 comprises a central unit 36 which is connected to the controlling unit 29, the word line driver 22, the plate line driver 23 and the multiplexing unit 28. The central unit 36 comprises an input for receiving instructions controls the writing and reading of data to and from the memory cells 15, 16, 17, 18.

If the central unit 36 receives the instruction to write a date into the second memory cell 16, the central unit 36 sends a respective writing signal to the controlling unit 29 of the writing unit 6. If a date "1" has to be written into the second memory cell 16, the controlling unit 29 controls the second amplifier 8 in such a way that the second amplifier 8 applies a high voltage on the second bit line 12. The high voltage may be higher than the threshold voltage of the PMC cell of the second memory cell 16. Additionally, the central unit 36 sends a control signal to the word line driver 22 that the word line 20 has to be set to a high voltage in order to close the switches 19 of the first, the second, the third and the fourth memory cells 15, 16, 17, 18, connecting the memory cells to the respective first, second, third, fourth bit line 11, 12, 13, 14.

Advantageously, the controlling unit 29 also sends a controlling signal to the first, the third, the fourth amplifier 7, 9, 10 in order to apply a writing voltage to the respective first, third and fourth bit line 11, 13, 14, although only a date should be written into the second memory cells 16. The writing voltage of the first, third and fourth bit line 11, 13, 14 corresponds to the data that are stored in the first, third and fourth memory cell 15, 17, 18. If a date "0" is stored, an erase voltage is applied and if a date "1" is stored, a program voltage is applied to the respective bit line. This writing operation has the advantage that the adjacent bit lines 11, 12, 13, 14 are at the writing voltage level at the same time that corresponds to the data stored in their memory cells. Thus, crosstalk has less impact during the writing operation. In a further embodiment of the invention data are always written at the same time into memory cells 15, 16, 17, 18, which are connected to bit lines that are arranged adjacent. Although in this method a writing voltage is put on the adjacent bit lines 11, 12, 13, 14 and this reduces the risk of a crosstalk that damages the voltages of the adjacent bit lines 11, 12, 13, 14.

For reading out data from a second memory cell 16, the central unit 36 sends a read out signal to the controlling unit 29, the word line driver 22 and the multiplexing unit 28. If the data of the second memory cell 16 is to be read out, the controlling unit 29 controls the second amplifier 8 in such a way that the second amplifier 8 puts a read out voltage on the second bit line 12 which is lower than the threshold voltage required for programming the PMC cell. Additionally, the word line driver 22 applies a high voltage to the word line 20 to close the switches of the first, second, third and fourth memory cell 15, 16, 17, 18. Additionally, the multiplexing unit 28 puts a high level signal on the second controlling line 33 closing the second further switch 25. Therefore, the sensing unit 30 connected to the output of the multiplexing unit 28 senses a small or a high current depending on the resistance state of the PMC cell of the second memory cell. Depending on the value of the current, the sensing unit 30 detects a low or a high resistance, i.e. "0" or "1" stored in the second memory cell. A respective current value is given out by the sensing unit 30 by the further output 31.

The use of the multiplexing unit 28 has the advantage that one output unit 30 is used for several bit lines. Thus, area is spared on the CBRAM.

The writing operation and the reading operation of data into or out of the first, the third and the fourth memory cell 15, 17, 18 is the same as explained above for the second memory cell 16. The difference is merely that the writing unit 6 activates the respective amplifiers and the multiplexing unit 28 closes the respective further switches by reading out data from the first, the third or the fourth memory cell 15, 17, 18. During the writing operation, at least the neighbored bit lines of the bit line of the memory cell into which a date should be written, are put to a writing voltage corresponding to the data stored in the memory cells or corresponding to data that should be written in the memory cells. Thus, the influence of voltage crosstalk between neighbored bit lines is reduced.

In addition to the described writing and reading operations, the voltage on the plate line 28 may also be changed during a writing and/or reading operation of a data of a memory cell 15, 16, 17, 18. Particularly during writing data in a memory cell, a high voltage drop should be generated across the PMC cell of the respective memory cell. Therefore, it may be advantageous not only to increase the voltage of the bit line of the respective memory cell, but also to decrease the voltage on the plate line 21 in order to increase the voltage drop over the PMC cell of the respective memory cell.

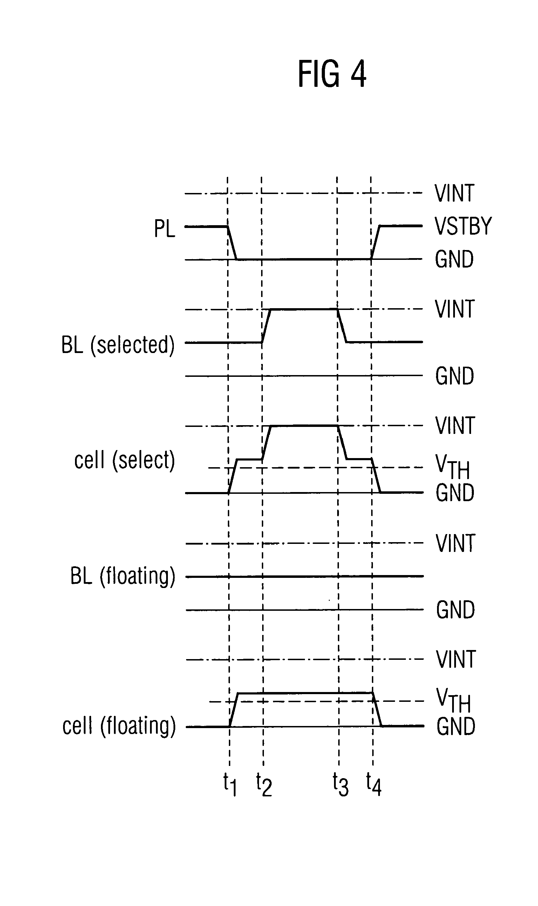

Figure 4 depicts a diagram of the plate line voltage PL, the voltage of a selected bit line BL and the voltage drop of a selected PMC cell CELL that is connected to the selected bit line. Furthermore, a voltage behavior of an unselected bit line according to the state of the art that floats is depicted BL (floating), and the voltage drop over an unselected PMC cell is depicted, cell (floating). The selected and the unselected bit lines are arranged side by side.

At a first point of time t1, the voltage on the plate line 21 is lowered from a standby voltage VSTBY to ground GND. Additionally, the voltage of the word line is at a high level, thus resulting in a closed switch of the memory cell. The voltage of the word line is not depicted in Figure 4. The lowering of the voltage on the plate line causes an increase of the voltage drop over the PMC cell of the selected memory cell as the voltage on the selected bit line is at this time in the region of a standby voltage VSTBY. At a second point of time t2, the writing unit 6 raises the voltage applied to the selected bit line up to the internal voltage VINT. This results in a higher voltage drop over the selected PMC cell. The voltage drop over the selected PMC cell is higher than the voltage threshold necessary to program the PMC cell from a high to a low resistive state. Setting the voltage of the plate line to the ground voltage GND and setting the selected bit line to the high internal voltage VINT results in a voltage drop of the internal voltage VINT, as is shown in the diagram.

If an adjacent bit line is not selected as it is depicted as a floating bit line BL (floating) in the diagram, crosstalk might occur between the high voltage level of the selected bit line and the voltage level of the floating bit line, i.e. in the region of the standby voltage VSTBY, and may be higher than the voltage threshold required for programming the unselected PMC cell of the floating bit line. This voltage drop of the floating memory cell is depicted in Figure 4 in the bottom diagram. Thus, it may be necessary to set adjacent bit lines to the respective writing voltage corresponding to the stored data of the memory cells of the adjacent bit lines during a writing operation. Therefore, if the date "0" is stored in a neighbored memory cell corresponding to a high resistive state of the PMC cell of the respective memory cell and the date "1" is stored in the neighbored memory cell corresponding to a low resistive state of the PMC cell of the memory cell, a low voltage is applied to the first memory cell and a high voltage is applied to the bit line of the second memory cell during a writing operation of the second memory cell. Forcing the first bit line of the first memory cell to a low voltage level prevents the influence of voltage crosstalk between the second and the first bit line during a writing operation of the second memory cell causing a failure programming by crosstalk between the first and the second bit line.

### Reference list

- 1: PMC cell
- 2: First electrode
- 3: Electrolyte layer
- 4: Second electrode
- 5: CBRAM
- 6: Writing unit
- 7: First amplifier
- 8: Second amplifier
- 9: Third amplifier
- 10: Fourth amplifier
- 11: First bit line
- 12: Second bit line
- 13: Third bit line
- 14: Fourth bit line
- 15: First memory cell
- 16: Second memory cell
- 17: Third memory cell
- 18: Fourth memory cell
- 19: Switch
- 20: Word line
- 21: Plate line
- 22: Word line driver
- 23: Plate line driver
- 24: First further switch
- 25: Second further switch
- 26: Third further switch
- 27: Fourth further switch
- 28: Multiplexing unit
- 29: Controlling unit
- 30: Output unit
- 31: Further output
- 32: First controlling line
- 33: Second controlling line
- 34: Third controlling line
- 35: Fourth controlling line
- 36: Central unit

## Claims

1. Method for writing data in a memory cell (15, 16, 17, 18) of a conductive bridging random access memory (CBRAM), whereby the CBRAM memory comprises a plate line (21), bit lines (11, 12, 13, 14) and memory cells (15, 16, 17, 18), each memory cell comprises (15, 16, 17, 18) a programmable metallization cell (PMC) (1), whereby the memory cells (15, 16, 17, 18) are connected with a respective bit line (11, 12, 13, 14) and the plate line (21), whereby a first, a second and a third bit line (11, 12, 13, 14) is arranged side by side, whereby data is written in a first memory cell (15) by changing the resistance value of a first PMC cell (1) of the first memory cell (15) by applying a writing voltage to the first bit line (11) that is connected with the first memory cell (15), whereby the adjacent second and third bit line (12, 13) that are connected with a second and a third memory cell (16, 17) are put at the same time to writing voltages and data are written in the first, second and third memory cell (15, 16, 17) during the same writing cycle.

2. Method of claim 1, whereby during a writing operation the voltage on the plate line (21) is changed to a low level with respect to the voltage of the bit line for increasing a voltage drop over the PMC cell (1) to assist the programming of the PMC cell (1).

3. The method of claim 1, wherein the voltage on the plate line (21) is lowered when the voltage of the bit line (11, 12, 13, 14) is arisen to reduce the resistance value of the PMC cell (1).

4. The method of claim 1, wherein the voltage on the plate line (21) is increased when the voltage of the bit line (11, 12, 13, 14) is lowered to increase the resistance value of the PMC cell (1).

5. A memory circuit, comprising:
a plate line (21), bit lines (11, 12, 13, 14), and memory cells (15, 16, 17, 18), each memory cell comprises a programmable metallization cell (PMC) (1) with a solid electrolyte (3) which is adapted to selectively develop or diminish a conductive path depending on the applied electrical field, whereby a memory cell (15, 16, 17, 18) is arranged between a bit line (11, 12, 13, 14) and the plate line (21);
a writing unit (6), whereby the writing unit (6) is connected with bit lines (11, 12, 13, 14), that are arranged side by side, whereby the writing unit (6) is configured to change a resistive state of a PMC cells (1) to a programmed or erased state by applying a writing voltage to a bit line (11, 12, 13, 14) that is connected with the PMC cell (1);
a controlling unit (29) that is connected to the writing unit (6), whereby the controlling unit (29) is configured to control the writing unit (6) to apply a writing voltage to a bit line (11, 12, 13, 14) of a memory cell (15, 16, 17, 18) that is to be programmed and to apply a writing voltage to an adjacently arranged bit line (11, 12, 13, 14) of a further memory cell (15, 16, 17, 18), an output unit (30) that is connected with the bit lines (11, 12, 13, 14) for reading out data from the memory cells (15, 16, 17, 18).

6. Memory circuit of claim 5 comprising:
a multiplexer unit (28) that is connected with an input to several bit lines (11, 12, 13, 14) and with an output to an input of the output unit (30), whereby the multiplexer unit (28) is configured to select a bit line (11, 12, 13, 14) and to connect the selected bit line with the output unit (30).

7. Memory circuit of claim 5 comprising:
a voltage unit (23) that is connected with the plate line (21) and configured to apply a plate voltage to the plate line (21), wherein the voltage unit (23) is disposed to apply according to a writing or an erasing operation of the PMC cell (1) a high or a low voltage on the plate line (21) to increase the voltage drop over the PMC cell (1) to assist the writing and/or the erasing operation.

8. A CBRAM memory circuit, comprising:
a plate line, bit lines, word lines and memory cells, each memory cell comprising a switch and a programmable metallization cell (PMC) with a solid electrolyte which is adapted to selectively develop and diminish a conductive path depending on the applied electrical field, whereby a memory cell is arranged between a bit line and the plate line, whereby a controlling input of the switch is connected with a word line;
a word line driver circuit configured to select one of the word lines and to change the voltage of the selected word line to close or open the switches that are connected with the selected word line;
a writing unit configured to change a state of a PMC cell to a programmed state by applying a writing voltage to the bit line of the PMC cell;
a voltage unit connected with the plate line and configured to apply a plate voltage to the plate line according to a writing or an erasing operation of the PMC cell to increase the voltage drop over the PMC cell to assist the writing and/or the erasing operation,
a controlling unit (29) that is connected to the writing unit (6), whereby the controlling unit (29) is configured to control the writing unit (6) to apply a writing voltage to a bit line (11, 12, 13, 14) of a memory cell that is to be programmed and to apply a writing voltage to an adjacently arranged bit line (11, 12, 13, 14) of a further memory cell (15, 16, 17, 18),
an output unit (30) that is connected with the bit lines (11, 12, 13, 14) for reading out data from the memory cells (15, 16, 17, 18).
